# FASCICULE DE BREVET EUROPEEN

(11) **EP 4 187 570 B1**
(45) Date de publication et mention de la délivrance du brevet: **29.10.2025**
(21) Numéro de dépôt: 22208456.8
(22) Date de dépôt: 21.11.2022
(51) Int. Cl.: H01H 47/04, H01H 47/22, H01H 50/54

(54) **DISPOSITIF DE COMMUTATION ÉLECTROMÉCANIQUE D'UN CIRCUIT ÉLECTRIQUE DE PUISSANCE COMPORTANT AU MOINS UN SYSTÈME DE DÉTECTION DE LA POSITION EN CONTACT OU ÉCARTÉE D'UNE PALETTE D'UN CONTACTEUR**
ELEKTROMECHANISCHE SCHALTVORRICHTUNG FÜR EINE ELEKTRISCHE LEISTUNGSSCHALTUNG MIT MINDESTENS EINEM SYSTEM ZUR ERFASSUNG DER POSITION IN KONTAKT ODER IN DER LAGE EINER PALETTE EINES SCHÜTZES
ELECTROMECHANICAL SWITCHING DEVICE FOR AN ELECTRIC POWER CIRCUIT COMPRISING AT LEAST ONE SYSTEM FOR DETECTING THE POSITION IN CONTACT OR MOVED AWAY FROM A PALLET OF A CONTACTOR

(30) Priorité: 29.11.2021 FR 2112621
(43) Date de publication de la demande: 31.05.2023
(73) Titulaire: AIRBUS OPERATIONS (S.A.S.), 31060 Toulouse (FR)
(72) Inventeur: ROUSSET, David, 31060 Toulouse (FR); LACOSTE, Jean-Marc, 31060 Toulouse (FR)
(74) Mandataire: Fantin, Laurent

(56) Documents cités:
- WO-A1-98/24106
- FR-A1- 2 607 318
- US-A1- 2014 002 945

## Description

La présente demande se rapporte à un dispositif de commutation électromagnétique d'un circuit électrique de puissance comportant au moins un système de détection de la position en contact ou écartée d'une palette d'un contacteur.

Le document FR 2 607 318 A1 décrit un dispositif de commutation selon le préambule de la revendication 1.

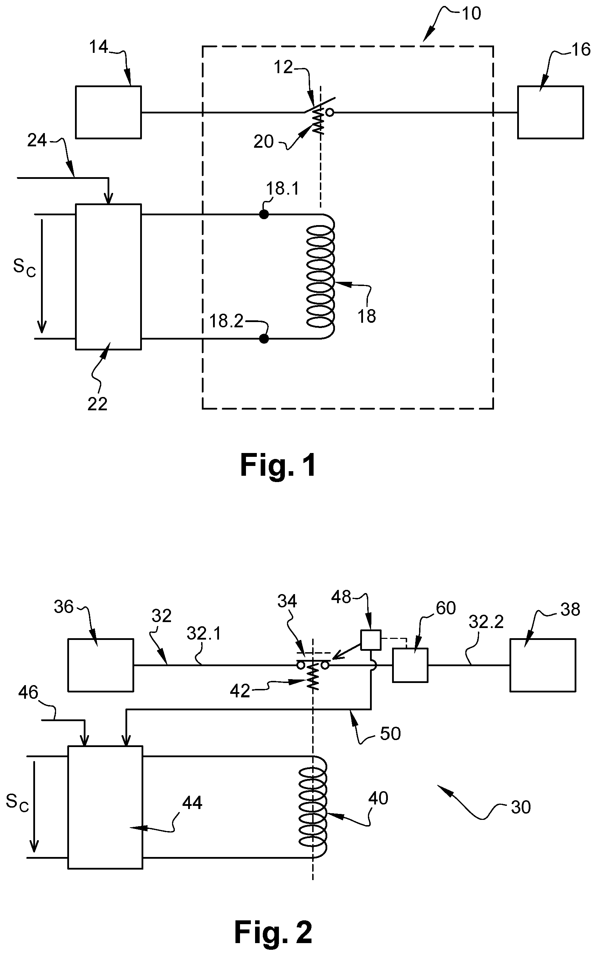

Selon un mode de réalisation visible sur la figure 1, un dispositif de commutation 10 d'un circuit électrique de puissance comprend :
- au moins un contacteur principal 12 configuré pour occuper un état ouvert dans lequel il isole une source électrique 14 et une charge électrique 16 du circuit électrique de puissance ainsi qu'un état fermé dans lequel il relie la source électrique 14 et la charge électrique 16,
- une bobine 18 configurée pour provoquer la fermeture du contacteur principal 12 et son maintien à l'état fermé lorsque la bobine 18 est alimentée,
- un ressort 20 configuré pour provoquer l'ouverture du contacteur principal 12 et son maintien à l'état ouvert lorsque la bobine 18 n'est plus alimentée,
- une alimentation de commande 22 configurée pour appliquer un signal de commande Sc aux première et deuxième bornes d'extrémité 18.1, 18.2 de la bobine 18 à réception d'un signal 24 et maintenir ce signal de commande Sc tant que le contacteur principal 12 doit rester à l'état fermé.

Un tel dispositif de commutation électromécanique est adapté pour des tensions de l'ordre de 115 V pour le circuit électrique de puissance, inférieures à 300 V, et n'est pas adapté pour des tensions supérieures, de l'ordre de 1000 V. A ces tensions, des courants de court-circuit atteignant plusieurs kilos ampères peuvent apparaître et générer des phénomènes de « lévitation » qui tendent à initier l'ouverture du contacteur principal 12 malgré l'action de la bobine 18. Cette ouverture non désirée du contacteur principal 12 provoque des arcs électriques qui peuvent mener à sa dégradation partielle ou totale.

La présente invention vise à remédier à tout ou partie des inconvénients de l'art antérieur.

A cet effet, l'invention a pour objet un dispositif de commutation comprenant au moins un contacteur principal ainsi qu'un tronçon amont et un tronçon aval d'un circuit électrique de puissance positionnés de part et d'autre du contacteur principal, ledit contacteur principal étant configuré pour occuper des états ouvert et fermé ; le dispositif de commutation comprenant un ressort, une alimentation de commande ainsi qu'un actionneur configuré pour provoquer un changement de l'état ouvert vers l'état fermé du contacteur principal à l'encontre d'un effort généré par le ressort lorsque l'actionneur est alimenté par un signal de commande généré par l'alimentation de commande égal à un premier niveau, le ressort étant agencé de manière à provoquer un changement de l'état fermé vers l'état ouvert du contacteur principal lorsque l'actionneur n'est pas alimenté ; le contacteur principal comprenant une palette ainsi qu'au moins une borne, la palette étant configurée pour occuper une position en contact avec ladite borne et une position écartée de ladite borne. Selon l'invention, le dispositif de commutation comprend un système de détection configuré pour déterminer la position en contact ou écartée de la palette du contacteur principal, générer au moins un deuxième signal en fonction de la position déterminée de la palette du contacteur principal et transmettre ledit deuxième signal à l'alimentation de commande. En complément, l'alimentation de commande est configurée pour générer un signal de commande visant à maintenir le contacteur principal à l'état fermé à réception du deuxième signal. En complément, l'alimentation de commande est configurée pour que le signal de commande soit égal au premier niveau pendant une première durée donnée à compter de la réception d'un premier signal puis à un deuxième niveau, inférieur au premier niveau, pour maintenir le contacteur principal à l'état fermé tant que le contacteur principal doit être maintenu à l'état fermé, et à un troisième niveau supérieur au deuxième niveau à réception du deuxième signal émis par le système de détection.

Cette solution permet de manière simple et efficace de détecter les phénomènes de lévitation et de les contrer en renforçant l'effort exercé par l'actionneur sur le contacteur principal afin de le maintenir à l'état fermé.

Selon une autre caractéristique, le signal de commande est maintenu au troisième niveau tant que le système de détection détermine que la palette est dans la position écartée.

Selon une autre caractéristique, le troisième niveau est supérieur ou égal au premier niveau. Selon un premier mode de réalisation, le contacteur principal comporte une borne ou des première et deuxième bornes. En complément, le système de détection comprend au moins un capteur de mesure d'une tension configuré pour mesurer une tension entre la palette et au moins l'une des première et deuxième bornes ou entre les première et deuxième bornes. Selon une autre caractéristique, le capteur de mesure d'une tension est configuré pour transmettre un deuxième signal à l'alimentation de commande lorsque la tension mesurée est supérieure à un seuil de tension donné.

Selon une autre caractéristique, le capteur de mesure d'une tension est configuré pour transmettre un deuxième signal à l'alimentation de commande de manière continue dès que la tension mesurée est supérieure au seuil de tension donné et jusqu'à ce que la tension mesurée redevienne inférieure ou égale au seuil de tension donné.

Selon un autre mode de réalisation, le système de détection comprend au moins un contacteur secondaire relié à la palette du contacteur principal ainsi qu'un circuit secondaire comprenant ledit contacteur secondaire, le contacteur secondaire étant configuré pour occuper un état fermé lorsque la palette du contacteur principal est dans la position en contact et un état ouvert lorsque la palette du contacteur principal est dans la position écartée, le circuit secondaire étant configuré pour générer un deuxième signal lorsque le contacteur secondaire est à l'état ouvert.

Selon un autre mode de réalisation, le système de détection comprend au moins un capteur de mesure d'une distance configuré pour mesurer une distance séparant ledit capteur de mesure d'une distance et la palette.

Selon une autre caractéristique, le capteur de mesure d'une distance et la palette sont séparés d'une distance donnée lorsque la palette est dans la position en contact, le capteur de mesure d'une distance étant configuré pour transmettre un deuxième signal à l'alimentation de commande lorsqu'une différence entre la distance mesurée et la distance donnée est supérieure à un seuil de distance donné.

Selon une autre caractéristique, le capteur de mesure d'une distance est configuré pour transmettre un deuxième signal à l'alimentation de commande de manière continue dès que la différence entre la distance mesurée et la distance donnée est supérieure au seuil de distance donné et jusqu'à ce que la différence entre la distance mesurée et la distance donnée redevienne inférieure ou égale au seuil de distance donné.

Selon une autre caractéristique, le circuit électrique de puissance comprend un système de limitation de courant configuré pour agir en fonction de la position de la palette déterminée par le système de détection.

D'autres caractéristiques et avantages ressortiront de la description de l'invention qui va suivre, description donnée à titre d'exemple uniquement, en regard des dessins annexés parmi lesquels :
- La figure 1 est un schéma d'un dispositif de commutation d'un circuit électrique de puissance illustrant un mode de réalisation de l'art antérieur,
- La figure 2 est un schéma d'un dispositif de commutation d'un circuit électrique de puissance illustrant un mode de réalisation de l'invention,
- La figure 3 est un schéma d'un système de détection de l'état de la palette d'un contacteur illustrant un premier mode de réalisation, la palette étant en position en contact,
- La figure 4 est un schéma du système de détection visible sur la figure 3, la palette étant en position écartée,
- La figure 5 est un schéma d'un système de détection de l'état de la palette d'un contacteur illustrant un deuxième mode de réalisation, la palette étant en position en contact,
- La figure 6 est un schéma du système de détection visible sur la figure 5, la palette étant en position écartée,
- La figure 7 est un schéma d'un système de détection de l'état de la palette d'un contacteur illustrant un troisième mode de réalisation, la palette étant en position en contact,
- La figure 8 est un schéma du système de détection visible sur la figure 7, la palette étant en position écartée.

Sur la figure 2, un dispositif de commutation 30 d'un circuit électrique de puissance 32 comprend au moins un contacteur principal 34 ainsi qu'un tronçon amont 32.1 et un tronçon aval 32.2 du circuit électrique de puissance 32 positionnés de part et d'autre du contacteur principal 34. Le contacteur principal 34 est configuré pour occuper un état ouvert (visible en pointillés), dans lequel il isole le tronçon amont 32.1 du tronçon aval 32.2 et interdit le passage d'un courant, ainsi qu'un état fermé dans lequel il relie les tronçons amont et aval 32.1, 32.2 et autorise le passage d'un courant. Selon une application non limitative, le contacteur principal 34 est utilisé pour relier ou isoler au moins une source électrique 36 et au moins une charge électrique 38 dans un circuit électrique de puissance d'un aéronef. Le contacteur principal 34 est configuré pour fonctionner à des tensions élevées, supérieures à 300 V, de l'ordre de 1000 V. Bien entendu, il pourrait fonctionner à des tensions inférieures de l'ordre de 115 V.

Le dispositif de commutation 30 comprend :
- un actionneur 40 configuré pour provoquer la fermeture du contacteur principal 34 et son maintien à l'état fermé lorsque l'actionneur est alimenté,
- un ressort 42 configuré pour provoquer l'ouverture du contacteur principal 34 et son maintien à l'état ouvert lorsque l'actionneur 40 n'est plus alimenté,
- une alimentation de commande 44 configurée pour appliquer un signal de commande Sc à l'actionneur 40 à réception d'un premier signal 46 et maintenir ce signal de commande Sc tant que le contacteur principal 34 doit rester à l'état fermé.

Le signal de commande Sc peut être une énergie, une tension, une intensité ou toute autre grandeur physique.

Selon un mode de réalisation, l'actionneur 40 est une bobine comportant des première et deuxième bornes d'extrémité auxquelles est appliqué le signal de commande Sc.

Quel que soit le mode de réalisation, l'actionneur 40 est configuré pour provoquer un changement de l'état ouvert vers l'état fermé du contacteur principal 34 à l'encontre d'un effort généré par le ressort 42 lorsque l'actionneur 40 est alimenté par un signal de commande Sc à un premier niveau, le ressort 42 provoquant un changement de l'état fermé vers l'état ouvert du contacteur principal 34 lorsque l'actionneur 40 n'est pas alimenté.

L'actionneur 40 peut être utilisé pour contrôler l'état de plusieurs contacteurs principaux 34. Selon un mode de réalisation, le ressort 42 est configuré de manière à ce qu'un effort de maintien exercé par l'actionneur 40 pour le maintenir comprimé soit moindre qu'un effort de commutation exercé par l'actionneur 40 pour provoquer sa compression.

Ainsi, l'actionneur 40, sollicité par le signal de commande Sc à un premier niveau, exerce un effort de commutation pour provoquer un changement d'état du contacteur principal 34 supérieur à un effort de maintien du contacteur principal 34 dans un état donné lorsque l'actionneur 40 est sollicité par le signal de commande Sc à un deuxième niveau, inférieur au premier niveau.

L'alimentation de commande 44 est configurée pour générer un signal de commande Sc égal à :
- un premier niveau pendant une première durée donnée à compter de la réception du premier signal 46 pour provoquer un changement d'état du contacteur principal 34 (passage de l'état ouvert à l'état fermé),
- un deuxième niveau, inférieur au premier niveau, pour maintenir le contacteur principal 34 à l'état fermé tant que le contacteur principal 34 doit être maintenu à l'état fermé.

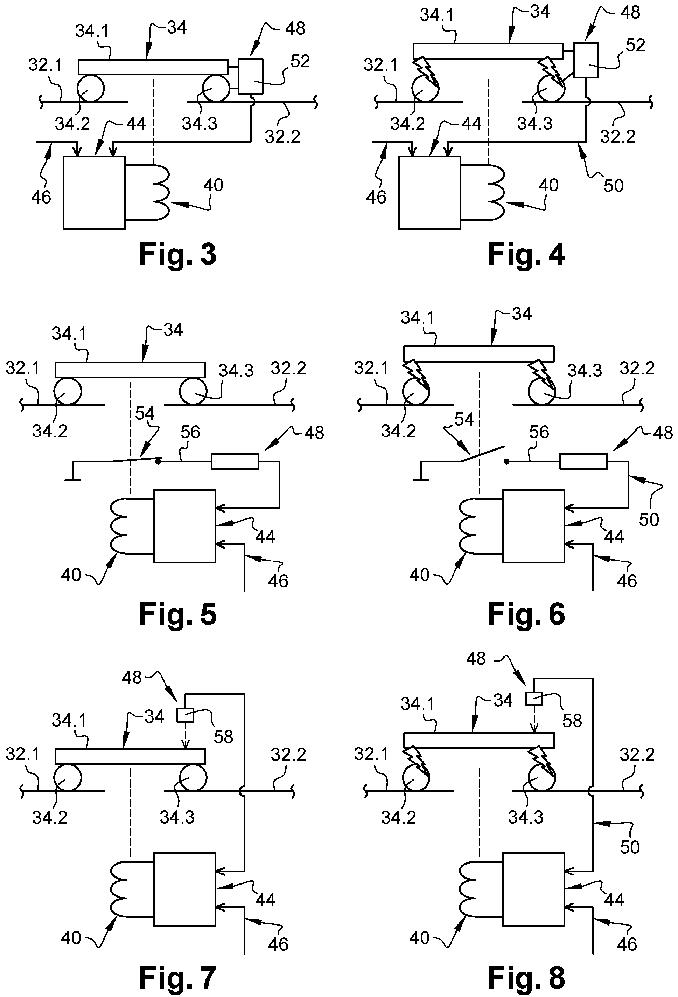

Selon un mode de réalisation visible en détails sur les figures 3 à 8, le contacteur principal 34 comprend une palette 34.1 ainsi que des première et deuxième bornes 34.2, 34.3 reliées respectivement aux tronçons amont et aval 32.1, 32.2, la palette 34.1 étant simultanément en contact avec les première et deuxième bornes 34.2, 34.3 lorsque le contacteur principal 34 est à l'état fermé, comme illustré sur les figures 3, 5 et 7, la palette 34.1 étant écartée d'au moins une des première et deuxième bornes 34.2, 34.3 lorsque le contacteur principal 34 est à l'état ouvert, comme illustré sur les figures 4, 6 et 8.

Selon un autre mode de réalisation, le contacteur principal 34 comprend une palette pivotante reliée en permanence à un premier tronçon parmi les tronçons amont et aval 32.1, 32.2 ainsi qu'une borne reliée à un deuxième tronçon, différent du premier tronçon, parmi les tronçons amont et aval 32.1, 32.2, la palette étant en contact avec la borne lorsque le contacteur principal 34 est à l'état fermé et écartée de ladite borne lorsque le contacteur principal 34 est à l'état ouvert.

Quel que soit le mode de réalisation, le contacteur principal 34 comprend une palette 34.1 ainsi qu'au moins une borne 34.2, la palette 34.1 étant configurée pour occuper une position en contact avec ladite borne 34.2 lorsque le contacteur principal 34 est à l'état fermé et une position écartée de ladite borne lorsque le contacteur principal 34 est à l'état ouvert.

En fonctionnement, un courant nominal ne dépassant pas un seuil de fonctionnement de l'ordre de plusieurs centaines d'ampères circule dans le circuit électrique de puissance 32. Dans certaines circonstances, un courant de court-circuit dépassant le seuil de fonctionnement, de l'ordre de plusieurs kilos ampères, peut circuler dans le circuit électrique de puissance 32.

Ce courant de court-circuit peut générer des phénomènes de « lévitation » qui tendent à initier l'ouverture du contacteur principal 34 malgré l'action de l'actionneur 40. Dans cette situation, la palette 34.1 du contacteur principal 34 est dans la position écartée alors que l'actionneur 40 est configuré pour maintenir le contacteur principal 34 à l'état fermé.

Le dispositif de commutation 30 comprend un système de détection 48 configuré pour déterminer la position en contact ou écartée de la palette 34.1 du contacteur principal 34, générer au moins un deuxième signal 50 en fonction de la position déterminée (en contact ou écartée) de la palette 34.1 du contacteur principal 34 et transmettre ledit deuxième signal 50 à l'alimentation de commande 44.

L'alimentation de commande 44 est configurée pour générer un signal de commande Sc égal à un troisième niveau, supérieur au deuxième niveau, appliqué à l'actionneur 40 à réception du deuxième signal 50 émis par le système de détection 48 pour maintenir le contacteur principal 34 à l'état fermé. Plus particulièrement, l'actionneur 40 exerce un effort plus important sur la palette 34.1 afin de la maintenir plaquée contre les première et deuxième bornes 34.2, 34.3.

Selon une configuration, le troisième niveau est supérieur ou égal au premier niveau.

Le signal de commande Sc est maintenu au troisième niveau tant que le système de détection 48 détermine que la palette 34.1 est dans la position écartée. Lorsque le système de détection 48 détermine que la palette 34.1 est revenue dans la position en contact, le signal de commande Sc est de nouveau au deuxième niveau.

Selon un premier mode de réalisation visible sur les figures 3 et 4, le système de détection 48 comprend au moins un capteur de mesure d'une tension 52, comme un voltmètre par exemple, configuré pour mesurer une tension entre la palette 34.1 et au moins l'une des première et deuxième bornes 34.2, 34.3 ou entre les première et deuxième bornes 34.2, 34.3. Selon une première configuration, le capteur de mesure d'une tension 52 comprend un premier connecteur relié à la palette 34.1 ainsi qu'un deuxième connecteur relié à l'une des première ou deuxième bornes 34.2, 34.3, notamment celle au niveau de laquelle la palette 34.1 s'écarte en priorité en cas de phénomènes de lévitation.

Selon une deuxième configuration, le système de détection 48 comprend un premier capteur de mesure d'une tension présentant un premier connecteur relié à la palette 34.1 et un deuxième connecteur relié à la première borne 34.2 ainsi qu'un deuxième capteur de mesure de tension présentant un premier connecteur relié à la palette 34.1 et un deuxième connecteur relié à la deuxième borne 34.3.

Selon une autre configuration, le capteur de mesure d'une tension 52 est relié aux première et deuxième bornes 34.2, 34.3.

En fonctionnement, la tension mesurée par chaque capteur de mesure d'une tension 52 est nulle ou quasi-nulle lorsque la palette 34.1 est dans la position en contact, comme illustré sur la figure 3, et supérieure à un seuil de tension donné, non nul, lorsque la palette 34.1 est dans la position écartée, comme illustré sur la figure 4, lorsque survient un phénomène de lévitation. En complément, chaque capteur de mesure d'une tension 52 est configuré pour transmettre un deuxième signal 50 à l'alimentation de commande 44 lorsque la tension mesurée est supérieure au seuil de tension donné. Selon une configuration, chaque capteur de mesure d'une tension 52 est configuré pour transmettre un deuxième signal 50 à l'alimentation de commande 44 de manière continue dès que la tension mesurée est supérieure au seuil de tension donné et jusqu'à ce que la tension mesurée redevienne inférieure ou égale au seuil de tension donné.

Selon un deuxième mode de réalisation visible sur les figures 5 et 6, le système de détection 48 comprend au moins un contacteur secondaire 54 relié au contacteur principal 34, plus particulièrement à sa palette 34.1, et prévu au niveau d'un circuit secondaire 56. Le contacteur secondaire 54 est configuré pour occuper un état fermé lorsque la palette 34.1 du contacteur principal 34 est dans la position en contact et un état ouvert lorsque la palette 34.1 du contacteur principal 34 est dans la position écartée.

Le circuit secondaire 56 est configuré pour générer un deuxième signal 50 lorsque le contacteur secondaire 54 est à l'état ouvert. Selon une configuration, le circuit secondaire 56 génère un deuxième signal 50 lorsque le contacteur secondaire 54 est à l'état ouvert comme illustré sur la figure 6, ce qui correspond à la position écartée du contacteur principal 34 et aucun signal ou un signal différent du deuxième signal 50 lorsque le contacteur secondaire 54 est à l'état fermé comme illustré sur la figure 5, ce qui correspond à la position en contact du contacteur principal 34.

Selon un troisième mode de réalisation visible sur les figures 7 et 8, le système de détection 48 comprend au moins un capteur de mesure d'une distance 58 configuré pour mesurer une distance séparant ledit capteur 58 et la palette 34.1. Ce capteur de mesure d'une distance 58 est positionné de manière judicieuse au droit d'une zone de la palette 34.1 se déplaçant en cas de phénomènes de lévitation.

En fonctionnement, la distance mesurée par chaque capteur de mesure d'une distance 58 est égale à une distance donnée lorsque la palette 34.1 est dans la position en contact, comme illustré sur la figure 7, et différente de la distance donnée lorsque la palette 34.1 est dans la position écartée, comme illustré sur la figure 8, lorsque survient un phénomène de lévitation. En complément, chaque capteur de mesure d'une distance 58 est configuré pour transmettre un deuxième signal 50 à l'alimentation de commande 44 lorsque la différence entre la distance mesurée et la distance donnée est supérieure à un seuil de distance donné qui peut être nul. Selon une configuration, chaque capteur de mesure d'une distance 58 est configuré pour transmettre un deuxième signal 50 à l'alimentation de commande 44 de manière continue dès que la différence entre la distance mesurée et la distance donnée est supérieure au seuil de distance donné et jusqu'à ce que la différence entre la distance mesurée et la distance donnée redevienne inférieure ou égale au seuil de distance donné.

Bien entendu, l'invention n'est pas limitée aux capteurs de mesure d'une tension ou d'une distance 52, 58 ou au contacteur secondaire 54 pour déterminer la position en contact ou écartée de la palette 34.1 du contacteur principal 34.

Comme décrit dans le document EP2210262, l'alimentation de commande 44 peut comprendre un circuit de commande reliant une borne intermédiaire de la bobine et la deuxième borne d'extrémité de la bobine, ledit circuit de commande comportant un contacteur auxiliaire configuré pour occuper alternativement des états ouvert et fermé contrôlés par la bobine ainsi qu'un système de limitation de courant réarmable, les contacteurs principal et auxiliaire étant configurés pour commuter simultanément.

Selon un mode de réalisation visible sur la figure 2, le circuit électrique de puissance 32 comprend un système de limitation de courant 60 configuré pour agir en fonction de la position de la palette 34.1, déterminée par le système de détection 48. Ainsi, le système de limitation de courant 60 est configuré pour occuper un état désactivé tant que le système de détection 48 détermine que la palette 34.1 est dans la position en contact et un état activé lorsque le système de détection 48 détermine que la palette 34.1 est dans la position écartée en raison d'un phénomène de lévitation. A l'état désactivé, le système de limitation de courant 60 n'induit aucun impact sur le courant circulant dans le circuit électrique de puissance 32. A l'état activé, le système de limitation de courant 60 régule le courant circulant dans le circuit électrique de puissance 32.

Selon une configuration, le système de limitation de courant 60 est réarmable et reste à l'état activé tant que le système de détection 48 détermine que la palette 34.1 est dans la position écartée et redevient à l'état désactivé lorsque le système de détection 48 détermine que la palette 34.1 est revenue dans la position en contact.

Un tel dispositif de commutation 30 présente les avantages suivants : il permet bien évidemment d'éviter le phénomène de lévitation en cas de court-circuit, il permet également d'optimiser le poids et l'encombrement d'un tel dispositif et d'augmenter la fiabilité du circuit électrique de puissance 32 grâce à la diminution du nombre de composants électroniques dédiés à la détection de court-circuit et à l'activation de la protection associée et il permet de plus de dimensionner un dispositif de commutation 30 adapté à chaque contacteur 34.

## Revendications

1. Dispositif de commutation (30) comprenant au moins un contacteur principal (34) ainsi qu'un tronçon amont (32.1) et un tronçon aval (32.2) d'un circuit électrique de puissance (32) positionnés de part et d'autre du contacteur principal (34), ledit contacteur principal (34) étant configuré pour occuper des états ouvert et fermé, le dispositif de commutation (30) comprenant un ressort (42), une alimentation de commande (44) ainsi qu'un actionneur (40) configuré pour provoquer un changement de l'état ouvert vers l'état fermé du contacteur principal (34) à l'encontre d'un effort généré par le ressort (42) lorsque l'actionneur (40) est alimenté par un signal de commande généré par l'alimentation de commande (44) égal à un premier niveau, le ressort (42) étant agencé de manière à provoquer un changement de l'état fermé vers l'état ouvert du contacteur principal (34) lorsque l'actionneur (40) n'est pas alimenté, le contacteur principal (34) comprenant une palette (34.1) ainsi qu'au moins une borne (34.2), la palette (34.1) étant configurée pour occuper une position en contact avec ladite borne (34.2) et une position écartée de ladite borne (34.2) ; le dispositif de commutation (30) comprenant un système de détection (48) configuré pour déterminer la position en contact ou écartée de la palette (34.1) du contacteur principal (34), générer au moins un deuxième signal (50) en fonction de la position déterminée de la palette (34.1) du contacteur principal (34) et transmettre ledit deuxième signal (50) à l'alimentation de commande (44) et l'alimentation de commande (44) étant configurée pour générer un signal de commande visant à maintenir le contacteur principal (34) dans l'état fermé à réception du deuxième signal (50) et l'alimentation de commande (44) étant configurée pour que le signal de commande soit égal au premier niveau pendant une première durée donnée à compter de la réception d'un premier signal (46) puis à un deuxième niveau, inférieur au premier niveau, pour maintenir le contacteur principal (34) à l'état fermé tant que le contacteur principal (34) doit être maintenu à l'état fermé, et **caractérisé en ce que** l'alimentation de commande (44) est configurée pour que le signal de commande soit égal à un troisième niveau supérieur au deuxième niveau à réception du deuxième signal (50) émis par le système de détection (48).

2. Dispositif de commutation (30) selon la revendication précédente, **caractérisé en ce que** le signal de commande est maintenu au troisième niveau tant que le système de détection (48) détermine que la palette (34.1) est dans la position écartée.

3. Dispositif de commutation (30) selon la revendication précédente, **caractérisé en ce que** le troisième niveau est supérieur ou égal au premier niveau.

4. Dispositif de commutation (30) selon l'une des revendications précédentes, le contacteur principal (34) comportant une borne ou des première et deuxième bornes (34.2, 34.3), **caractérisé en ce que** le système de détection (48) comprend au moins un capteur de mesure d'une tension (52) configuré pour mesurer une tension entre la palette (34.1) et au moins l'une des première et deuxième bornes (34.2, 34.3) ou entre les première et deuxième bornes (34.2, 34.3).

5. Dispositif de commutation (30) selon la revendication précédente, **caractérisé en ce que** le capteur de mesure d'une tension (52) est configuré pour transmettre un deuxième signal (50) à l'alimentation de commande (44) lorsque la tension mesurée est supérieure à un seuil de tension donné.

6. Dispositif de commutation (30) selon la revendication précédente, **caractérisé en ce que** le capteur de mesure d'une tension (52) est configuré pour transmettre un deuxième signal (50) à l'alimentation de commande (44) de manière continue dès que la tension mesurée est supérieure au seuil de tension donné et jusqu'à ce que la tension mesurée redevienne inférieure ou égale au seuil de tension donné.

7. Dispositif de commutation (30) selon l'une des revendications 1 à 3, **caractérisé en ce que** le système de détection (48) comprend au moins un contacteur secondaire (54) relié à la palette (34.1) du contacteur principal (34) ainsi qu'un circuit secondaire (56) comprenant ledit contacteur secondaire (54), le contacteur secondaire (54) étant configuré pour occuper un état fermé lorsque la palette (34.1) du contacteur principal (34) est dans la position en contact et un état ouvert lorsque la palette (34.1) du contacteur principal (34) est dans la position écartée, le circuit secondaire (56) étant configuré pour générer un deuxième signal (50) lorsque le contacteur secondaire (54) est à l'état ouvert.

8. Dispositif de commutation (30) selon l'une des revendications 1 à 3, **caractérisé en ce que** le système de détection (48) comprend au moins un capteur de mesure d'une distance (58) configuré pour mesurer une distance séparant ledit capteur de mesure d'une distance (58) et la palette (34.1).

9. Dispositif de commutation (30) selon la revendication précédente, **caractérisé en ce que** le capteur de mesure d'une distance (58) et la palette (34.1) sont séparés d'une distance donnée lorsque la palette (34.1) est dans la position en contact, le capteur de mesure d'une distance (58) étant configuré pour transmettre un deuxième signal (50) à l'alimentation de commande (44) lorsqu'une différence entre la distance mesurée et la distance donnée est supérieure à un seuil de distance donné.

10. Dispositif de commutation (30) selon la revendication précédente, **caractérisé en ce que** le capteur de mesure d'une distance (58) est configuré pour transmettre un deuxième signal (50) à l'alimentation de commande (44) de manière continue dès que la différence entre la distance mesurée et la distance donnée est supérieure au seuil de distance donné et jusqu'à ce que la différence entre la distance mesurée et la distance donnée redevienne inférieure ou égale au seuil de distance donné.

11. Dispositif de commutation (30) selon l'une des revendications précédentes, **caractérisé en ce que** le circuit électrique de puissance (32) comprend un système de limitation de courant (60) configuré pour agir en fonction de la position de la palette (34.1) déterminée par le système de détection (48).

## Patentansprüche

1. Schaltvorrichtung (30), mit wenigstens einem Hauptschütz (34) sowie einem stromaufwärts gelegenen Abschnitt (32.1) und einem stromabwärts gelegenen Abschnitt (32.2) einer elektrischen Leistungsschaltung (32), die auf beiden Seiten des Hauptschützes (34) angeordnet ist, wobei das Hauptschütz (34) so eingerichtet ist, dass es einen offenen und einen geschlossenen Zustand einnimmt, wobei die Schaltvorrichtung (30) eine Feder (42) aufweist, eine Steuersignalversorgung (44) sowie einen Aktuator (40), der so eingerichtet ist, dass er eine Änderung des Hauptschützes (34) von dem offenen Zustand in den geschlossenen Zustand gegen eine von der Feder (42) erzeugte Kraft bewirkt, wenn der Aktuator (40) mit einem von der Steuersignalversorgung (44) erzeugten Steuersignal versorgt wird, das gleich einem ersten Pegel ist, wobei die Feder (42) so angeordnet ist, dass sie eine Änderung des Hauptschützes (34) von dem geschlossenen Zustand in den offenen Zustand bewirkt, wenn der Aktuator (40) nicht mit Strom versorgt wird, wobei der Hauptschütz (34) eine Platte (34.1) sowie wenigstens einen Anschluss (34.2) aufweist, wobei die Platte (34.1) so eingerichtet ist, dass sie eine den Anschluss (34.2) kontaktierende Position und eine von dem Anschluss (34.2) entfernte Position einnimmt; wobei die Schaltvorrichtung (30) ein Erfassungssystem (48) aufweist, das so eingerichtet ist, dass es die kontaktierende oder entfernte Position der Platte (34.1) des Hauptschalters (34) bestimmt, dass es wenigstens ein zweites Signal (50) in Abhängigkeit von der bestimmten Position der Platte (34.1) des Hauptschützes (34) erzeugt und dass es das zweite Signal (50) an die Steuersignalversorgung (44) überträgt, wobei die Steuersignalversorgung (44) so eingerichtet ist, dass sie ein Steuersignal erzeugt, um das Hauptschütz (34) bei Empfang des zweiten Signals (50) im geschlossenen Zustand zu halten, und wobei die Steuersignalversorgung (44) so eingerichtet ist, dass das Steuersignal für eine erste gegebene Zeitdauer ab dem Empfang eines ersten Signals (46) gleich dem ersten Pegel ist und dann auf einem zweiten Pegel ist, der niedriger als der erste Pegel ist, um das Hauptschütz (34) im geschlossenen Zustand zu halten, solange das Hauptschütz (34) im geschlossenen Zustand gehalten werden muss, und **dadurch gekennzeichnet, dass** die Steuersignalversorgung (44) so eingerichtet ist, dass das Steuersignal bei Empfang des zweiten Signals (50), das von dem Erfassungssystem (48) ausgegeben wird, gleich einem dritten Pegel ist, der höher als der zweite Pegel ist.

2. Schaltvorrichtung (30) nach dem vorhergehenden Anspruch, **dadurch gekennzeichnet, dass** das Steuersignal auf dem dritten Pegel gehalten wird, solange das Erfassungssystem (48) feststellt, dass sich die Platte (34.1) in der entfernten Position befindet.

3. Schaltvorrichtung (30) nach dem vorhergehenden Anspruch, **dadurch gekennzeichnet, dass** der dritte Pegel größer oder gleich dem ersten Pegel ist.

4. Schaltvorrichtung (30) nach einem der vorhergehenden Ansprüche, wobei das Hauptschütz (34) einen Anschluss oder erste und zweite Anschlüsse (34.2, 34.3) aufweist, **dadurch gekennzeichnet, dass** das Erfassungssystem (48) wenigstens einen Spannungsmesssensor (52) aufweist, der so eingerichtet ist, dass er eine Spannung zwischen der Platte (34.1) und wenigstens einem der ersten und zweiten Anschlüsse (34.2, 34.3) oder zwischen den ersten und zweiten Anschlüssen (34.2, 34.3) misst.

5. Schaltvorrichtung (30) nach dem vorhergehenden Anspruch, **dadurch gekennzeichnet, dass** der Sensor zum Messen einer Spannung (52) so eingerichtet ist, dass er ein zweites Signal (50) an die Steuersignalversorgung (44) überträgt, wenn die gemessene Spannung über einem gegebenen Spannungsschwellenwert liegt.

6. Schaltvorrichtung (30) nach dem vorhergehenden Anspruch, **dadurch gekennzeichnet, dass** der Sensor zum Messen einer Spannung (52) so eingerichtet ist, dass er kontinuierlich ein zweites Signal (50) an die Steuersignalversorgung (44) überträgt, sobald die gemessene Spannung über dem gegebenen Spannungsschwellenwert liegt, und bis die gemessene Spannung wieder kleiner oder gleich dem gegebenen Spannungsschwellenwert wird.

7. Schaltvorrichtung (30) nach einem der Ansprüche 1 bis 3, **dadurch gekennzeichnet, dass** das Erfassungssystem (48) wenigstens ein Sekundärschütz (54), das mit der Platte (34.1) des Hauptschützes (34) verbunden ist, sowie eine Sekundärschaltung (56) aufweist, die das Sekundärschütz (54) umfasst, wobei das Sekundärschütz (54) so eingerichtet ist, dass es einen geschlossenen Zustand einnimmt, wenn die Platte (34.1) des Hauptschützes (34) in der kontaktierenden Position ist, und einen offenen Zustand, wenn die Platte (34.1) des Hauptschützes (34) in der entfernten Position ist, wobei die Sekundärschaltung (56) so eingerichtet ist, dass sie ein zweites Signal (50) erzeugt, wenn sich das Sekundärschütz (54) in dem offenen Zustand befindet.

8. Schaltvorrichtung (30) nach einem der Ansprüche 1 bis 3, **dadurch gekennzeichnet, dass** das Erfassungssystem (48) wenigstens einen Abstandsmesssensor (58) aufweist, der so eingerichtet ist, dass er einen Abstand zwischen dem Abstandsmesssensor (58) und der Platte (34.1) misst.

9. Schaltvorrichtung (30) nach dem vorhergehenden Anspruch, **dadurch gekennzeichnet, dass** der Abstandsmesssensor (58) und die Platte (34.1) um einen gegebenen Abstand voneinander getrennt sind, wenn sich die Platte (34.1) in der kontaktierenden Position befindet, wobei der Abstandsmesssensor (58) so eingerichtet ist, dass er ein zweites Signal (50) an die Steuersignalversorgung (44) sendet, wenn eine Differenz zwischen dem gemessenen Abstand und dem gegebenen Abstand größer als ein gegebener Abstandsschwellenwert ist.

10. Schaltvorrichtung (30) nach dem vorhergehenden Anspruch, **dadurch gekennzeichnet, dass** der Sensor zur Messung eines Abstands (58) so eingerichtet ist, dass er kontinuierlich ein zweites Signal (50) an die Steuersignalversorgung (44) sendet, sobald die Differenz zwischen dem gemessenen Abstand und dem gegebenen Abstand größer als der gegebene Abstandsschwellenwert ist, und bis die Differenz zwischen dem gemessenen Abstand und dem gegebenen Abstand wieder kleiner oder gleich dem gegebenen Abstandsschwellenwert wird.

11. Schaltvorrichtung (30) nach einem der vorhergehenden Ansprüche, **dadurch gekennzeichnet, dass** die elektrische Leistungsschaltung (32) ein Strombegrenzungssystem (60) aufweist, das so eingerichtet ist, dass es in Abhängigkeit von der Position der Platte (34.1) wirkt, die von dem Erfassungssystem (48) bestimmt wird.

## Claims

1. Switching device (30) comprising at least one main contactor (34) and an upstream section (32.1) and a downstream section (32. 2) of an electric power circuit (32) positioned on either side of the main contactor (34), said main contactor (34) being configured to assume open and closed states, the switching device (30) comprising a spring (42), a control power supply (44) and an actuator (40) configured to cause the main contactor (34) to change from the open state to the closed state against a force generated by the spring (42) when the actuator (40) is powered by a control signal generated by the control power supply (44) that is equal to a first level, the spring (42) being arranged so as to cause the main contactor (34) to change from the closed state to the open state when the actuator (40) is not powered, the main contactor (34) comprising a blade (34.1) and at least one terminal (34.2), the blade (34.1) being configured to assume a position in contact with said terminal (34.2) and a position not in contact with said terminal (34.2); the switching device (30) comprising a detection system (48) configured to determine the contact or non-contact position of the blade (34.1) of the main contactor (34), to generate at least one second signal (50) as a function of the determined position of the blade (34.1) of the main contactor (34) and to transmit said second signal (50) to the control power supply (44), the control power supply (44) being configured to generate a control signal intended to keep the main contactor (34) in the closed state upon reception of the second signal (50), the control power supply (44) being configured so that the control signal is equal to the first level for a first given duration starting from the reception of a first signal (46) and then to a second level, lower than the first level, in order to keep the main contactor (34) in the closed state as long as the main contactor (34) has to be kept in the closed state, and **characterized in that** the control power supply (44) is configured so that the control signal is equal to a third level higher than the second level upon reception of the second signal (50) transmitted by the detection system (48).

2. Switching device (30) as claimed in the preceding claim, **characterized in that** the control signal is maintained at the third level as long as the detection system (48) determines that the blade (34.1) is in the non-contact position.

3. Switching device (30) as claimed in the preceding claim, **characterized in that** the third level is greater than or equal to the first level.

4. Switching device (30) as claimed in any of the preceding claims, the main contactor (34) comprising a terminal or first and second terminals (34.2, 34.3), **characterized in that** the detection system (48) comprises at least one voltage measurement sensor (52) configured to measure a voltage between the blade (34.1) and at least one of the first and second terminals (34.2, 34.3) or between the first and second terminals (34.2, 34.3).

5. Switching device (30) as claimed in the preceding claim, **characterized in that** the voltage measurement sensor (52) is configured to transmit a second signal (50) to the control power supply (44) when the measured voltage is greater than a given voltage threshold.

6. Switching device (30) as claimed in the preceding claim, **characterized in that** the voltage measurement sensor (52) is configured to continuously transmit a second signal (50) to the control power supply (44) as soon as the measured voltage is greater than the given voltage threshold and until the measured voltage drops below or is equal to the given voltage threshold.

7. Switching device (30) as claimed in any of claims 1 to 3, **characterized in that** the detection system (48) comprises at least one secondary contactor (54) connected to the blade (34.1) of the main contactor (34), and a secondary circuit (56) comprising said secondary contactor (54), the secondary contactor (54) being configured to assume a closed state when the blade (34.1) of the main contactor (34) is in the contact position and an open state when the blade (34.1) of the main contactor (34) is in the non-contact position, with the secondary circuit (56) being configured to generate a second signal (50) when the secondary contactor (54) is in the open state.

8. Switching device (30) as claimed in any of claims 1 to 3, **characterized in that** the detection system (48) comprises at least one distance measurement sensor (58) configured to measure a distance separating said distance measurement sensor (58) and the blade (34.1).

9. Switching device (30) as claimed in the preceding claim, **characterized in that** the distance measurement sensor (58) and the blade (34.1) are separated by a given distance when the blade (34.1) is in the contact position, with the distance measurement sensor (58) being configured to transmit a second signal (50) to the control power supply (44) when a difference between the measured distance and the given distance is greater than a given distance threshold.

10. Switching device (30) as claimed in the preceding claim, **characterized in that** the distance measurement sensor (58) is configured to continuously transmit a second signal (50) to the control power supply (44) as soon as the difference between the measured distance and the given distance is greater than the given distance threshold and until the difference between the measured distance and the given distance drops below or is equal to the given distance threshold.

11. Switching device (30) as claimed in any of the preceding claims, **characterized in that** the electric power circuit (32) comprises a current limiting system (60) configured to act as a function of the position of the blade (34.1) determined by the detection system (48).
